# EUROPEAN PATENT APPLICATION

(11) **EP 1 420 048 A2**
(43) Date of publication of application: **19.05.2004**
(21) Application number: 03021627.9
(22) Date of filing: 25.09.2003
(51) Int. Cl.: C08L 79/08, C09J 179/08, C08G 73/10, B32B 15/08, B32B 27/34

(54) **Metal laminate**

(30) Priority: 14.11.2002 JP 2002330365
(71) Applicant: Mitsui Chemicals, Inc., Tokyo 100-6070 (JP)
(72) Inventor: Kodama, Yoichi, Sodegaura-shi Chiba 299-0108 (JP); Mori, Minehiro, Sodegaura-shi Chiba 299-0108 (JP); Tashiro, Masayuki, Sodegaura-shi Chiba 299-0108 (JP); Ohtsubo, Eiji, Sodegaura-shi Chiba 299-0108 (JP); Nakazawa, Naoki, Sodegaura-shi Chiba 299-0108 (JP); Tanabe, Kenji, Sodegaura-shi Chiba 299-0108 (JP)
(74) Representative: HOFFMANN - EITLE

(57) **Abstract**

A heat resistance resin composition having superb low-temperature adhesiveness and a polyimide/metal laminate which is superior in solder heat resistance and hardly generates swelling when forming a Au-Sn bond or Au-Au bond, which are used for lead-free soldering and COF packaging. A metal laminate comprising a layer comprises a resin composition prepared by compounding a bismaleimide compound represented bythefollowing formula (1) in a polyamic acid and/or a polyimide: 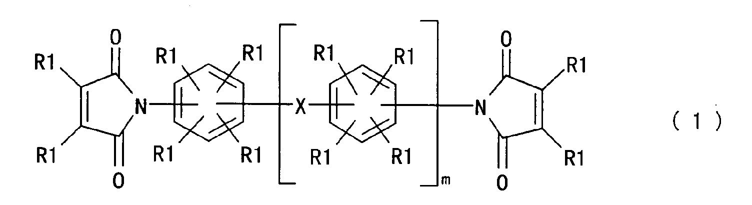 wherein m denotes an integer of 0 or more, each X independently represent O, SO₂, S, CO, CH₂, C(CH₃)₂, C(CF₃)₂ or a direct bond and each R1 independently represents a hydrogen atom, a halogen atom or a hydrocarbon group and is independent of any other R1 as to the substitution position on the benzene ring; and a metal foil layer, wherein the layer of the resin composition is formed on at least one surface of the metal foil layer. A resin composition for a metal laminate.

## Description

### TECHNICAL FIELD

The present invention relates to a metal laminate and a resin composition for a polyimide/metal laminate which are superior in low-temperature adhesiveness and also solder heat resistance.

### RELATED BACKGROUND ART

Polyimides are superior in heat resistance, chemical resistance, mechanical strength and electric characteristics and therefore have main applications as heat-resistant adhesives used not only in aeronautical fields in which heat resistance is demanded but also in electronics fields such as flexible print substrates, semiconductor packages and the like.

Recently, characteristics such as low-temperature adhesiveness in addition to heat resistance have come to be demanded of polyimide type heat-resistant adhesives from the viewpoint of the convenience in processing.

A resin composition comprising a polyimide resin having a siloxane unit, an epoxy resin and a phosphate type plasticizer is reported as a resin superior in low-temperature adhesiveness in Japanese Patent Laid-Open Publication No. 212468/1998. In this case, however, all of these components, namely, the polyimide resin, the epoxy resin and the plasticizer contain aliphatic units and therefore heat decomposition temperature is lowered, thereby causing problems concerning the heat resistance.

On the other hand, as resins having satisfactory adhesive strength and heat resistance, those constituted of a specific polyamic acid and bismaleimide compound have been developed as disclosed in, for instance, Japanese Patent Laid-Open Publication No. 289862/1989, Japanese Patent Laid-Open Publication No. 145638/1994 and Japanese Patent Laid-Open Publication No. 192639/1994. However, some of these resins, require temperatures of 300°C or more to be used as an adhesive and therefore, many of the resins are unsatisfactory from the viewpoint of low-temperature adhesiveness. Also, the applications of these resins are only limited to the production of films as is found in the Patent publications.

On the other hand, a lead-free solder has come to be used for packaging of electronic parts from the viewpoint of environmental safeguard and therefore a polyimide/metal laminate plate superior in solder heat resistance is being desired in the packaging process of chips and parts and also in processes, called "repair", for dismounting chips and parts. Also, in applications such as those called rigid flex or flexible multilayer substrates, it begins to be pointed out that the solder heat-resistant temperature, which has been conventionally required, is insufficient to achieve a sufficient reliability, and heat resistance at higher temperatures has come to be desired. In the case of using a metal laminate for a chip-on-film (hereinafter abbreviated as COF if necessary), an inner lead bonder or a flip chip bonder is used to bond a chip with a metal wire by a Au-Au bond or Au-Sn bond at temperatures as high as 300°C or more. Therefore, base materials superior in solder heat resistance are desired in cases they are used for COFs, too.

As a COF base material, non-thermoplastic polyimides are primarily used at present and polyimide/metal laminate plates obtained by sputtering a metal onto a polyimide film have been used (see Japanese Patent Laid-Open Publication No. 070762/1995). However, in the case of using the sputtering method, the yield tends to be decreased by the pinholes in the metal layer and a polyimide/metal laminate plate having no pinholes has been therefore desired.

### SUMMARY OF THE INVENTION

It is an object of the present invention to provide a resin composition for polyimide laminate having superb low-temperature adhesiveness.

Other objects of the present invention are to provide a polyimide/metal laminate plate which is superior in solder heat resistance and is free of pinholes and also to provide a polyimide/metal laminate plate which hardly generates swelling when forming a Au-Sn bond orAu-Au bond which are used for lead-free soldering and COF packaging, and is superior in solder heat resistance.

The inventors had an idea of using a flexible circuit substrate prepared by laminating a rolled copper foil or an electrolytic copper foil on a polyimide as a polyimide/metal laminate that is free of pinholes. However, the inventors have found that in the case of using a polyimide as an adhesive, there is a problem such as foaming depending on the type of polyimide. The inventors have made studies concerning this point and, as a result, found that low-temperature adhesiveness and solder heat resistance of the laminate are improved and also the above problem can be solved by compounding a specific bismaleimide compound with a polyamic acid and/or a polyimide, to complete the present invention.

Accordingly, the present invention is as shown below.
(1) A metal laminate comprising a layer of a resin composition prepared by compounding a bismaleimide compound represented by the following formula (1) in a polyamic acid and/or a polyimide and a layer of metal foil, wherein the layer of the resin composition is formed on at least one surface of the metal foil layer: 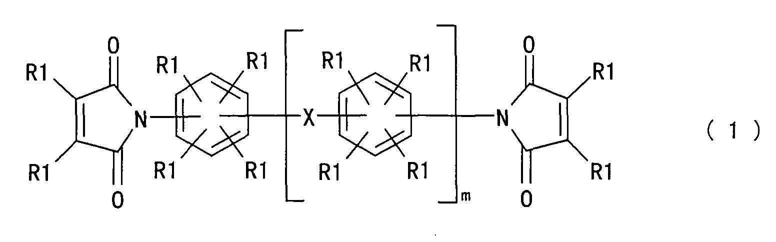 wherein m denotes an integer of 0 or more, each X independently represents O, SO₂, S, CO, CH₂, C(CH₃)₂, C(CF₃)₂ or a direct bond, each R1 independently represents a hydrogen atom, a halogen atom or a hydrocarbon group and is independent of any other R1 as to the substitution position on the benzene ring.
(2) The metal laminate according to (1) , wherein the metal laminate has a structure in which the layer of the resin composition is formed on one surface or both surfaces of one or more polyimide films and a metal foil layer is formed on one surface or both surfaces of the layer of resin composition.
(3) The metal laminate according to (1), wherein the polyamic acid and/or the polyimide have repeat structural units represented by the following formula (2) and/or formula (3) respectively: 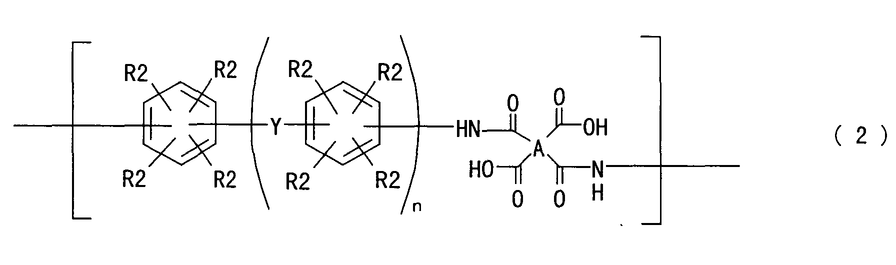 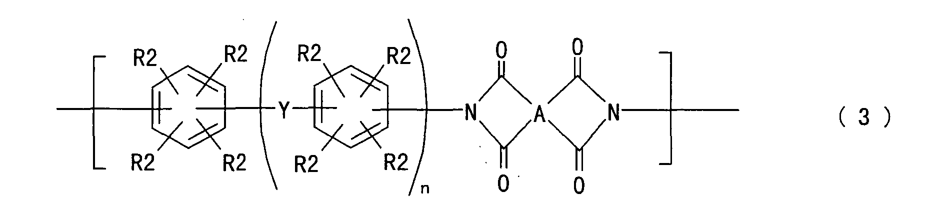 wherein n denotes an integer of 0 or more, each Y independently represents O, SO₂, S, CO, CH₂, C(CH₃)₂, C(CF₃)₂ or a direct bond, A represents a tetravalent organic group and each R2 independently represents a hydrogen atom, a halogen atom or a hydrocarbon group and is independent of any other R2 as to the substitution position on the benzene ring.
(4) The metal laminate according to (3), wherein the tetravalent organic group represented by A is selected from the organic groups represented by the following formulae (4): 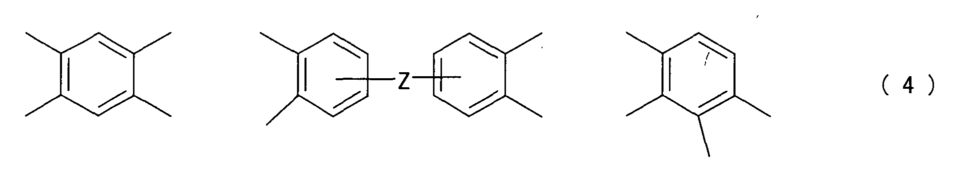 wherein Z represents O, SO₂, S, CO, CH₂, C(CH₃)₂, C(CF₃)₂ or a direct bond.
(5) A resin composition for polyimide/metal laminate obtainable compounding a bismaleimide compound represented by the following formula (1) in a polyamic acid and/or a polyimide: 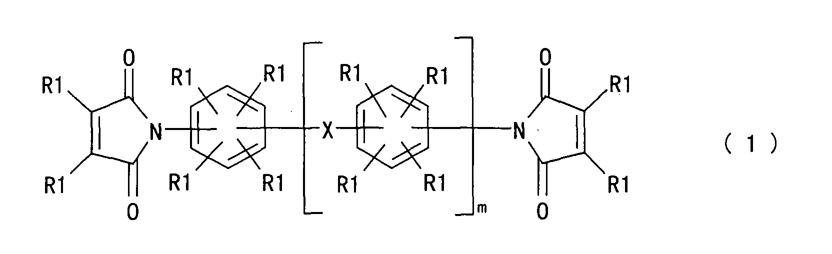 wherein m denotes an integer of 0 or more, each X independently represents O, SO₂, S, CO, CH₂, C(CH₃)₂, C(CF₃)₂ or a direct bond and each R1 independently represents a hydrogen atom, a halogen atom or a hydrocarbon group and is independent of any other R1 as to the substitution position on the benzene ring.
(6) A resin composition for polyimide/metal laminate comprising:
   a bismaleimide compound represented by the following formula (1): 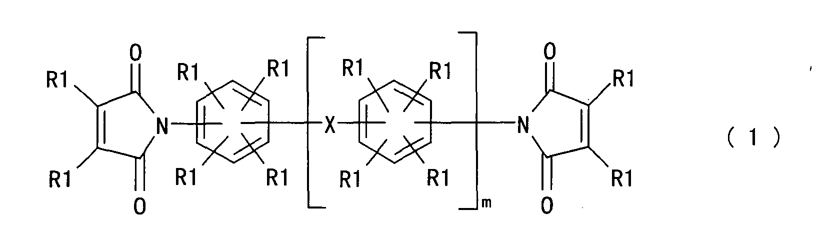 wherein m denotes an integer of 0 or more, each X independently represents O, SO₂, S, CO, CH₂, C(CH₃)₂, C(CF₃)₂ or a direct bond and each R1 independently represents a hydrogen atom, a halogen atom or a hydrocarbon group and is independent of any other R1 as to the substitution position on a benzene ring; and
   a polyamic acid and/or a polyimide.

### DESCRIPTION OF PREFERRED EMBODIMENTS

The present invention will be explained below in detail.

The present invention relates to a resin composition for polyimide laminate prepared by compounding a bismaleimide compound represented by the following formula (1) in a polyamic acid and/or a polyimide: 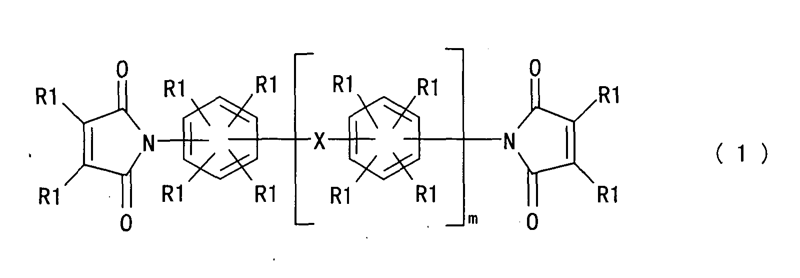 wherein m denotes an integer of 0 or more, each X independently represents O, SO₂, S, CO, CH₂, C(CH₃)₂, C(CF₃)₂ or a direct bond and each R1 independently represents a hydrogen atom, a halogen atom or a hydrocarbon group and is independent of any other R1 as to the substitution position on the benzene ring, and also to a metal laminate comprising a layer the resin composition formed on at least one surface of a metal foil layer.

In the formula (1), m denotes an integer of 0 or more, preferably an integer of from 0 to 6 andmore preferably an integer of from 0 to 4. Also, each X independently represents O, SO₂, S, CO, CH₂, C(CH₃)₂, C(CF₃)₂ or a direct bond and is preferably O, C(CH₃)₂ or a direct bond. Each R1 independently represents a hydrogen atom, a halogen atom or a hydrocarbon group and is independent of any other R1 as to the substitution position on the benzene ring. The bismaleimide compound is preferably a compound in which at least one X or N has a substitution position of ortho or metha to that of another X or N that is bonded to the same benzene ring.

Although no particular limitation is imposed on the polyamic acid and/or polyimide used in the present invention, the polyamic acid and/or polyimide preferably have repeat structural units represented by the following formula (2) and formula (3) respectively: 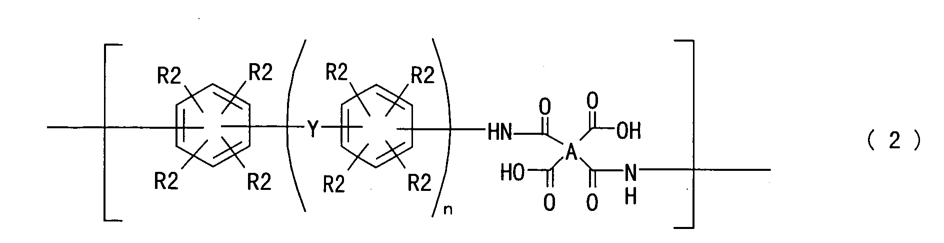 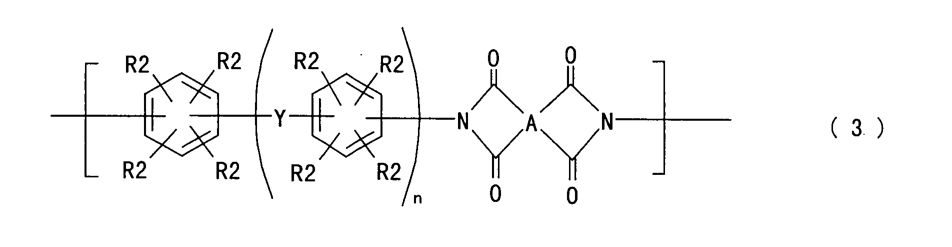 wherein n denotes an integer of 0 or more, each Y independently represents O, SO₂, S, CO, CH₂, C(CH₃)₂, C(CF₃)₂ or a direct bond, A represents a tetravalent organic group and each R2 independently represents a hydrogen atom, a halogen atom or a hydrocarbon group and is independent of any other R2 as to the substitution position on the benzene ring. The polyamic acid and/or polyimide more preferably have repeat structural units represented by the following formula (5) and/or formula (6) respectively: 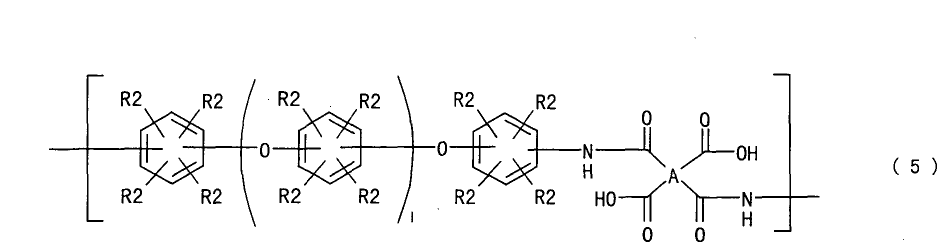 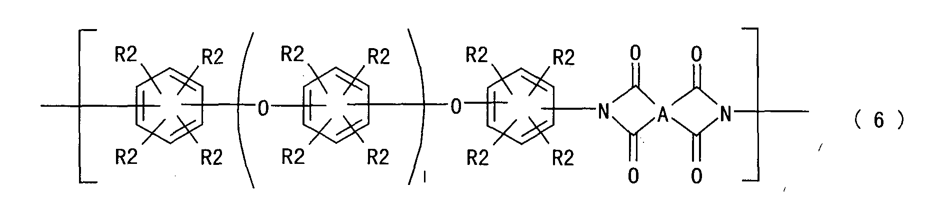 wherein l denotes an integer of from 1 to 7, each R2 independently represents a hydrogen atom, a halogen atom or a hydrocarbon group and is independent of any other R2 as to the substitution position on the benzene ring, and two hetero atoms, which are the same to each other or different from each other, are selected from the group consisting of oxygen atom and nitrogen atom and are bonded to the same benzene ring, are present at the ortho position or metha position each other in at least one benzene ring. A represents a tetravalent organic group. The polyamic acid and/or polyimide more preferably have repeat structural units represented by the following formula (7) and/or formula (8) respectively: 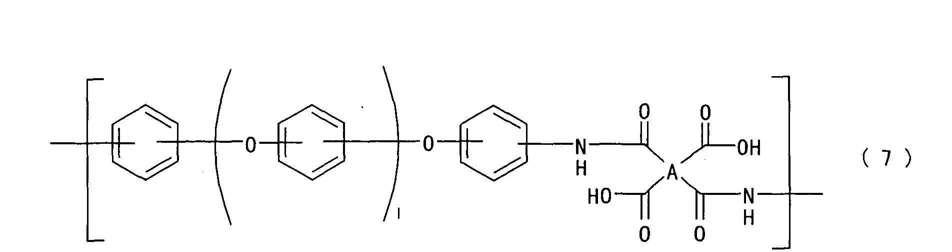 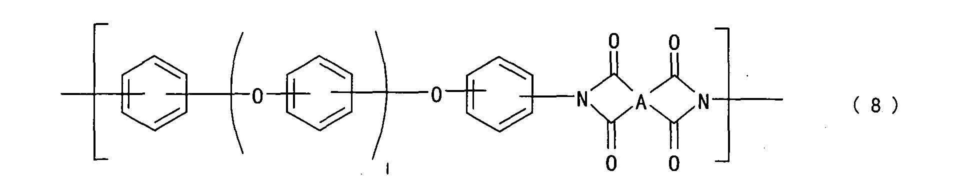 wherein l denotes an integer of from 1 to 7, two hetero atoms, which are the same to each other or different from each other, are selected from the group consisting of oxygen atom and nitrogen atom and bonded to the same benzene ring, are present at the ortho position ormetha position each other in at least one benzene ring. A represents a tetravalent organic group. The polyamic acid and/or polyimide still more preferably have repeat structural units represented by the following formula (9) and/or formula (10), respectively: 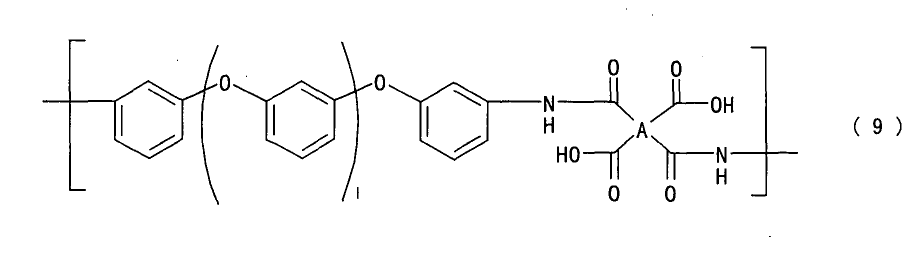 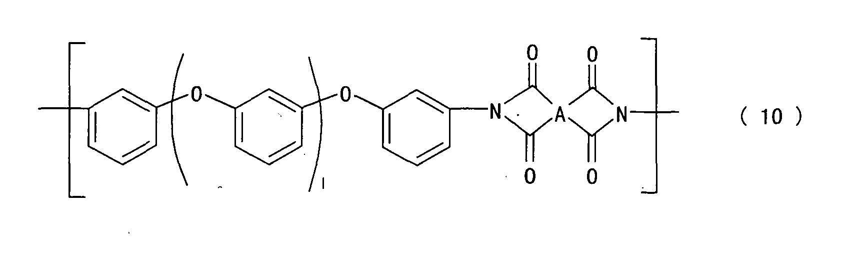 wherein l and A have the same meanings as above.

In the Formulae (2) and (3), n denotes an integer of 0 or more, preferably from 0 to 6 and more preferably from 0 to 4. In the formulae (5) to (10), 1 denotes an integer of from 1 to 7, preferably from 1 to 5 and more preferably from 1 to 3. Also, each Y independently represents O, SO₂, S, CO, CH₂, C (CH₃)₂, C (CF₃)₂ or a direct bond and preferably O, CO and C (CH₃)₂ or a direct bond.

In the formulae (2), (3), (5) and (6), each R2 independently represents a hydrogen atom, a halogen atom or a hydrocarbon group, is independent of any other R2 as to the substitution position on the benzene ring. In the formulae (2), (3), (5) and (6), it is preferable that at least one Y, N or O has a substitution position of ortho or metha to that of another Y, N or O that is bonded to the same benzene ring. Although there is no particular limitation to the tetravalent organic group represented by A in the formulae (2) to (3) and (5) to (10), specific examples of the organic group include tetravalent organic groups selected from the group consisting of aliphatic groups having 2 to 27 carbon atoms, alicyclic groups, monocyclic aromatic groups, condensed polycyclic aromatic groups and non-condensed polycyclic aromatic groups in which aromatic groups are connected with each other directly or through a crosslinking member. The tetravalent organic group is preferably one of those represented by the formulae in (4) below. 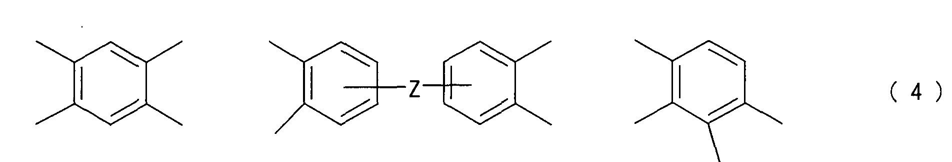 wherein Z represents O, SO₂, S, CO, CH₂, C(CH₃)₂, C(CF₃)₂ or a direct bond.

In the formulae (1) to (3), (5) and (6), examples of the halogen atom represented by R1 or R2 include a chlorine atom and fluorine atom, examples of the hydrocarbon group include lower alkyl groups such as methyl group and ethyl group, lower alkenyl groups such as vinyl group and allyl group, aralkyl groups such as benzyl group and phenethyl group, aryl groups such as phenyl group and naphthyl group, alkoxy groups such as methoxy group and ethoxy group and alkyl halide groups such as trifluoromethyl group.

Specific examples of the bismaleimide compound represented by the formula (1) may include, though not limited to, 1,3-bis(3-maleimidophenoxy)benzene, bis(3-(3-maleimidophenoxy)phenyl) ether, 1,3-bis(3-(3-maleimidophenoxy)phenoxy)benzene, bis(3-(3-(3-maleimidophenoxy)phenoxy)phenyl) ether, 1,3-bis(3-(3-(3-maleimidophenoxy)phenoxy)phenoxy)benzene, N,N'-p-phenylenebismaleimide, N,N'-m-phenylenebismaleimide, bis(4-maleimidophenyl)methane, N,N'-4,4'-diphenyl ether bismaleimide, N,N'-3,4'-diphenyl ether bismaleimide, N,N'-3,3'-diphenyl ketone bismaleimide, 2,2-bis(4-(4-maleimidophenoxy)phenyl)propane, 2,2-bis(4-(3-maleimidophenoxy)phenyl)propane, 4,4'-bis(3-maleimidophenoxy)biphenyl, 2,2-bis(4-(3-maleimidophenoxy)phenyl)-1,1,1,3,3,3-hexafluor opropane, bis(4-(3-maleimidophenoxy)phenyl)ketone, bis(4-(3-maleimidophenoxy)phenyl)sulfide and bis(4-(3-maleimidophenoxy)phenyl)sulfone.

These bismaleimide compounds may be produced from each corresponding diamine compound and maleic anhydride by a condensation and dehydration reaction according to, for example, the method described in the publication of JP-A No. 4-99764.

When producing the metal laminate of the present invention, the proportion of the bismaleimide compound to be compounded in the polyimide, though no particular limitation is imposed on it, is preferably from 0.1 to 70% by weight and more preferably from 0.1 to 50% by weight based on the total weight of the polyamic acid which is a precursor of the polyimide. When the amount of the bismaleimide compound to be compounded is less than 0.1% by weight, there is the case where the effect of improving solder heat resistance according to the aim of the present invention is not much observed, whereas when the amount exceeds 70% by weight, the adhesive strength to the metal foil tends to deteriorate.

Examples of the method of compounding the bismaleimide compound in the polyamic acid include, though not limited to, (i) a method in which the bismaleimide compound is added to a solution of the polyamic acid, (ii) a method in which the bismaleimide compound is added when polymerizing the polyamic acid, for example, when a diamine compound or a tetracarboxylic acid dianhydride is charged or during the course of polymerization and (iii) a method in which powder of the polyamic acid and the bismaleimide compound are mixed in the solid states.

Also, the polyamic acid may be dehydrated to a corresponding polyimide to prepare a polyimide solution, then the bismaleimide compound can be compounded in the polyamide solution.

The polyamic acid represented by the formula (2) is one obtained by reacting a diamine compound represented by the formula (11):
wherein n, Y and R2 have the same meanings as above; with a tetracarboxylic dianhydride represented by the formula (12): 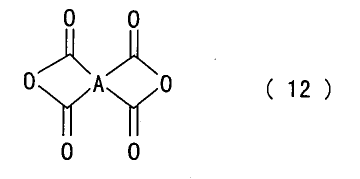 wherein A has the same meaning as above. A resin composition obtained by dehydrating the resin composition comprising the polyamic acid into a corresponding polyimide is also within the scope of the present invention.

Specific examples of the aromatic diamine compound represented by the formula (9) may include, though not limited to, bis(3-(3-aminophenoxy)phenyl) ether, 1,3-bis(3-(3-aminophenoxy)phenoxy)benzene, bis(3-(3-(3-aminophenoxy)phenoxy)phenyl) ether, 1,3-bis(3-(3-(3-aminophenoxy)phenoxy)phenoxy)benzene, o-phenylenediamine, p-phenylenediamine, m-phenylenediamine, 4,4'-diaminodiphenylmethane, 3,4'-diaminodiphenylmethane, 3,3'-diaminodiphenylmethane, 4,4'-diaminodiphenyl ether, 3,3'-diaminodiphenyl ether, 3,4'-diaminodiphenyl ether, 4,4'-diaminobenzophenone, 3,4'-diaminobenzophenone, bis(4-aminophenyl)sulfone, bis(4-(3-aminophenoxy)phenyl)sulfone, bis(3-aminophenyl) sulfide, bis(4-aminophenyl) sulfide, 1,3-bis(4-(4-aminophenoxy)-α,α-dimethylbenzyl)benzene, 4,4'-bis(3-aminophenoxy)biphenyl, 2,2-bis(4-aminophenoxyphenyl)propane, 1,3-bis(1-(4-(4-aminophenoxy)phenyl)-1-methylethyl)benzene, 1,4-bis(1-(4-(4-aminophenoxy)phenyl)-1-methylethyl)benzene, 1,4-bis(1-(4-(3-aminophenoxy)phenyl)-1-methylethyl)benzene, 2,2-bis(3-(3-aminophenoxy)phenyl)-1,1,1,3,3,3-hexafluoropro pane and 2,2-bis(3-(4-aminophenoxy)phenyl)-1,1,1,3,3,3-hexafluoropro pane.

In the formula (12), A represents a tetravalent organic group and specifically, for example, a tetravalent organic group selected from the group consisting of aliphatic groups having 2 to 27 carbon atoms, alicyclic groups, monocyclic aromatic groups, condensed polycyclic aromatic groups and non-condensed polycyclic aromatic groups in which aromatic groups are connected with each other directly or through a crosslinking member.

Also, there is no particular limitation on the tetracarboxylic dianhydride represented by the formula (12). Polyimides having a variety of glass transition temperatures can be obtained using conventionally known tetracarboxylic dianhydrides.

Specific examples of the tetracarboxylic dianhydride include pyromellitic dianhydride, 3,3',4,4'-biphenyltetracarboxylic dianhydride, oxy-4,4'-diphthalic dianhydride, 2,2-bis[4-(3,4-dicarboxyphenoxy)phenyl]propane dianhydride, ethylene glycol bistrimellitic dianhydride and 2,2-bis(3,4-dicarboxyphenyl)-1,1,1,3,3,3-hexafluoropropane dianhydride. Preferable examples include 2,2',3,3'-benzophenonetetraxarboxylic dianhydride, 3,3',4,4'-benzophenonetetracarboxylic dianhydride, 1,2-bis(3,4-dicarboxybenzoyl)benzene dianhydride, 1,3-bis(3,4-dicarboxybenzoyl)benzene dianhydride, 1,4-bis(3,4-dicarbixybenzoyl)benzene dianhydride, 2,2'-bis((3,4-dicarboxy)phenoxy)benzophenone dianhydride, 2,3'-bis((3,4-dicarboxy)phenoxy)benzophenone dianhydride, 2,4'-bis((3,4-dicarboxy)phenoxy)benzophenone dianhydride, 3,3'-bis((3,4-dicarboxy)phenoxy)benzophenone dianhydride, 3,4'-bis((3,4-dicarboxy)phenoxy)benzophenone dianhydride and 4,4'-bis((3,4-dicarboxy)phenoxy)benzophenone dianhydride. These compounds may be used either singly or in combinations of two or more.

As a method of producing the polyamic acid according to the present invention, methods capable of producing polyamides including known methods may all be applied. Among these methods, methods in which a reaction is run in an organic solvent are preferable. Examples of the solvent to be used in such a reaction include N,N-dimethylformamide, N,N-dimethylacetamide, N-methyl-2-pyrrolidone and 1,2-dimethoxyethane.

The concentration of the reaction raw material in this reaction is usually from 2 to 50% by weight and preferably from 10 to 50% by weight. The reaction temperature is usually 60°C or less and preferably 50°C or less. There is no particular limitation on the reaction pressure and the reaction can be run at normal pressure. Although the reaction time differs depending on the type of reaction raw material, the type of solvent and the reaction temperature, usually the reaction time of from 0.5 to 24 hours is enough to complete the reaction. The polyamic acid represented by the formula (2) is produced by such a polymerization-condensation reaction.

The polyimide represented by the formula (3) is obtained as follows: the above polyamic acid is imidized by heating at from 100 to 400°C or imidized chemically using an imidation agent such as acetic acid anhydride to obtain a polyimide having a repeat structural unit corresponding to the polyamic acid.

Also, the creation of a polyamic acid and the thermal imidation reaction can proceeds simultaneously by running a reaction at from 130°C to 250°C, whereby the polyimide according to the present invention can be obtained. Specifically, a diamine component and a dianhydride component are suspended or dissolved in an organic solvent and reacted under a heating condition at from 130 to 250°C to undergo the creation of a polyamic acid and the dehydration imidation simultaneously, whereby the polyimide according to the present invention can be obtained.

The resin composition for polyimide/metal laminate may contain another resin such as a polyethylene, a polypropylene, a polycarbonate, a polyallylate, a polyamide, a polysulfone, a polyether sulfone, a polyether ketone, a polyether ether ketone, a polyphenyl sulfide, a modified polyphenylene oxide group, a polyamidoimide, a polyether imide or an epoxy resin in an appropriate amount to the extent that the effect of the present invention is not impaired.

A film can be produced from the resin composition for polyimide/metal laminate of the present invention. There is no particular limitation to a method of the production of the film. Examples of the method include (i) a method in which a polyamic acid solution is coated on a substrate (a glass plate, metal plate or heat-resistant resin film) and then made into an imide compound by heating and (ii) a method in which a polyimide solution is coated on a substrate (a glass plate, metal plate or heat-resistant resin film) and then heated.

Also, an adhesive insulation tape may be made using an adhesive layer composed of the above resin composition and a heat-resistant film. The adhesive insulation tape may be a single sided tape, in which the adhesive layer is formed on only one surface of the heat-resistant film, or a double-sided tape, in which the adhesive layers are formed on the both surfaces of the heat-resistant film. The tapes may contain other optional layers besides the adhesive layer (s) and the heat-resistant film.

Also, when an adhesive insulation tape is produced from the polyimide metal laminate resin composition of the present invention, a solution containing the aforementioned resin composition may be coated on one surface or both surfaces of a heat-resistant film and dried. The thickness of the composition after the coating step in the process above is from 0.5 to 100 µm and preferably from 1 to 30 µm.

Examples of the heat-resistant film include films of heat-resistant resins such as a polyimide, a polyphenylene sulfide, a polyether, a polyether ketone, a polyether ether ketone and a polyethylene terephthalate and complex heat-resistant films such as epoxy resin-glass cloth and a epoxy resin-polyimide-glass cloth. Particularly, films made of polyimide resins are preferable from the viewpoint of heat resistance and dimensional stability. The thickness of the heat-resistant film is preferably from 5 to 130 µm and more preferably from 12.5 to 75 µm.

The metal laminate of the present invention may be prepared by forming a resin composition formulatedwith the aforementioned bismaleimide compound on at least one surface of a metal foil. The following is a specific example of the production method of the metal laminate: a varnish containing a thermoplastic polyimide or a polyamic acid which is a precursor of the thermoplastic polyimide, in which the bismaleimide compound represented by the formula (1) is compounded, is coated on a non-thermoplastic polyimide film, dried and cured to form a thermoplastic polyimide layer, and then the surface of the metal is thermocompression-bonded on the surface of the thermoplastic polyamide layer to form the laminate.

In the metal laminate of the present invention, an adhesive layer composed of the aforementioned resin composition and a metal foil are essential components. A Single or plural adhesive layers or non-adhesive layers composed of other resin compositions may further exist as intermediate layers between the adhesive layer and the metal foil.

Also, the metal laminate of the present invention may contain the resin composition comprising the bismaleimide compound represented by the formula (1) in any one layer of the laminate and also may has plural layers of the resin composition comprising the aforementioned compound.

In one example of the method for producing the metal laminate of the present invention, a solution containing the aforementioned resin composition is be coated on a metal foil and dried. In this method, the thickness of the composition after the coating is preferably in the range of from 0.5 to 100 µm. If the thickness is less than 0.5 µm, sufficient adhesiveness can not be obtained in some cases. If the thickness exceeds 100 µm, the adhesiveness is not much improved in some cases.

As to the type of metal foil, all known metal foils and alloy foils may be used. However, rolled copper foils, electrolytic copper foils, copper alloy foils and stainless foils are preferable from the viewpoint of cost, heat conductivity and rigidity. As to the thickness of the metal foil, a metal foil having a thickness of from 2 to 150 µm may be utilized and the thickness is preferably is in the range of from 2 to 105 µm, though no particular limitation is imposed on the thickness as far as it is thick enough to use the metal foil in a tape form.

It is more preferable that the metal laminate of the present invention have a structure in which a polyimide layer is formed on one surface or both surfaces of one or more polyimide films and a metal is laminated on one surface or both surfaces of the polyimide layer, wherein the polyimide layer comprises a resin composition containing a bismaleimide compound represented by the formula (1).

As the polyimide film, a non-thermoplastic polyimide film is preferable and, specifically, a film comprising a composition synthesized from a specific diamine and a specific tetracarboxylic dianhydride may be used. Examples of the specific diamine include o-phenylenediamine, p-phenylenediamine, m-phenylenediamine, 4,4'-diaminophenyl ether, 3,4'-diaminodiphenyl ether and 3,3'-diaminodiphenyl ether. These diamines may be used either singly or in combinations of two or more.

Examples of the specific tetracarboxylic dianhydride include a pyromellitic dianhydride, 3,3',4,4'-biphenyltetracarboxylic dianhydride and 2,2',3,3'-biphenyltetracarboxylic dianhydride. These tetracarboxylic dianhydrides may be used either singly or in combinations of two or more.

Also, as the non-thermoplastic polyimide film, commercially available non-thermoplastic polyimide films may be used. Examples of these commercially available non-thermoplastic polyimide films include Upilex (trademark) S, Upilex (trademark) SGA and Upilex (trademark) SN (product name, manufactured by Ube Industries, Ltd.), Kapton (trademark) H, Kapton (trademark) V and Kapton (trademark) EN (product name, manufactured by Toray Du Pont Co., Ltd.), Apical (trademark) AH, Apical (trademark) NPI and Apical (trademark) HP (products name, manufactured by Kanegafuchi Chemical Industry Co. , Ltd.). The surface of the non-thermoplastic resin film may be processed by plasma treatment, corona discharge treatment or the like.

As the thickness of the non-thermoplastic polyimide layer, a thickness in the range of from 5 to 250 µm is preferable, though no particular limitation is imposed on the thickness, which varies depending on the object.

Furthermore, a non-thermoplastic polyimide having a different structure may be laminated on the side, on which the thermoplastic polyimide layer has not been laminated, of the commercially available non-thermoplastic polyimide film.

Also, in the present invention, a peelable protective f ilm, a carrier film or a carrier metal foil may be present on the polyimide film, the adhesive insulation tape or the adhesive layer of the metal laminate. Examples of materials for the protective film or the carrier film include polyethylene, polyethylene terephthalate and polypropylene. Examples of the carrier metal foil include a rolled copper foil, an electrolytic copper foil, a copper alloy foil and a stainless foil. The thickness of the peelable film is in the range of from 1 to 200 µm and preferably from 10 to 100 µm. Also, the 90°peel strength of the peelable film to the adhesive layer is preferably in the range of from 0.01 to 10 kN/m.

The polyimide metal laminate provided by the present invention has such a conspicuous effect that it has high solder heat resistance. Conventional resins using bismaleimide have been known as heat-resistant resins. However, this heat resistance means high heat-decomposition temperature and has no direct relationship with solder heat resistance. To state in more detail, as is seen in the prior art, the 5% weight loss temperature of a resin obtained from bismaleimide and a diamine is about 400°C, whereas the 5% weight loss temperature of a polyimide, even if it is a thermoplastic polyimide, is about 500°C and therefore has high heat resistance. However, the solder heat resistance of a metal laminate using a conventionally used thermoplastic polyimide is 260°C or less at most and such a metal laminate has come to be unable to cope with the recent trend to higher working temperatures. As the measures taken for this, a trial has been made to use a thermoplastic polyimide having a high glass transition temperature. However, the temperature required for laminating the thermoplastic polyimide with ametal foil increases, giving rise to, for example, the problems that satisfactory adhesive strength is not achieved in conventional processes and also the thermoplastic polyimide can not completely fill in unevenness on the surface of the metal foil, causing the generation of defects called voids. In the present invention, by mixing bismaleimide with a polyimide, the glass transition temperature is lowered, thereby making the lamination with a metal easy and also making it possible to further improve the solder heat resistance by about 20°C or more from those of conventional techniques.

### EXAMPLES

The present invention will be explained in more detail by way of examples, which however, are not limiting the present invention.

The properties of polyimides in the examples were measured according to the following methods.

Glass transition temperature (Tg): measured at a temperature-rise rate of 10°C /min using a differential scanning calorimeter (DSC3110, manufactured by Mac Science Co., Ltd.).

In the case where Tg was not determined by means of a DSC method, it was determined from the peak of a loss elastic modulus (E") obtained using a solid viscoelasticity-measuring device RSAII (manufactured by Rheometrics Scientific, Inc.) at a frequency of 1 Hz and a temperature rise rate of 5°C /min.

90° peel strength: measured according to IPC-TM-650 method 2.4.9.

Also, a solder heat-resistance test in the examples was carried out according to IPC-TM-650 method 2. 4. 13. (Defined by the Institute for Interconnecting and Packaging Electronic Circuits) The test was made at solder temperatures of 240°C, 260°C, 280°C, 300°C, 320°C and 340°C to define a solder heat-resistant temperature. The highest temperature at which swelling and discoloration of the interface between a metal and a polyimide not occurred was determined as the solder heat-resistant temperature. As the samples, those conditioned (kept) at a temperature of 85°C and a relative humidity of 85% for 50 hours were used.

### EXAMPLE 1

A container equipped with a stirrer and a nitrogen-introducing pipe was charged with 12.00 g of 1,3-bis(3-aminophenoxy)benzene, 15.94 g of 1,3-bis(3-maleimidophenoxy)benzene and 48.70 g of N,N-dimethylacetamide and the mixture was stirred at 50°C for one hour in a nitrogen atmosphere. Then, the system temperature was cooled to ambient temperature, 11.90 g of 3,3',4,4'-benzophenonetetracarboxylic dianhydride was added stepwise with securing the solution from a sudden temperature rise, and then the system temperature was heated again to 50°C, followed by stirring for 4 hours.

A part of the polyamic acid solution containing the bismaleimide compound was taken, cast on a glass plate and then heated from 50°C to 270°C at a temperature rise rate of 7°C /min to obtain a film having the thickness of 20 µm. The glass transition temperature (Tg) of the obtained polyimide film was 106°C.

Also, another part of the polyamic acid solution containing the bismaleimide compound was cast on a copper foil (SLP-35, manufactured by Nippon Electrolysis Co., Ltd., thickness: 35 µm) and heated from 50°C to 270°C at a temperature rise rate of 7°C /min to obtain a metal laminate having a polyimide thickness of 12 µm.

In order to evaluate low-temperature adhesiveness, this metal laminate was thermocompression-bonded to a copper foil (SLP-35, manufactured by Nippon Electrolysis Co., Ltd., thickness: 35 µm) using a pulse bonder (TC-1320UD, manufactured by Kell Co. , Ltd.) in the condition of 190°C, 3 MPa and 2 seconds. Using the obtained test pieces, a peel test was made according to an IPC-TM-650 method 2.4.9. The adhesive strength was 1.6 kN/m.

### EXAMPLES 2 TO 4

The same procedures as in Example 1 as to polymerization, formulation and evaluation were conducted except that the type and amount of the diamine compound or the bismaleimide compound were altered. The types, the amounts and the results are shown together in Table 1.
1,3-bis(3-(3-aminophenoxy)phenoxy)benzene, 1,3-bis(3-(3-(3-aminophenoxy)phenoxy)phenoxy)benzene and 1,3-bis(3-(3-maleimidophenoxy)phenoxy)benzene were identified using ¹H-NMR and FD-mass.
1,3-bis(3-(3-aminophenoxy)phenoxy)benzene: ¹H-NMR (CD3SOCD3) δ: 5.24(s, 4H), 6.12-6.16(ddd, 2H, J = 7.83, 2.43, 0.82 Hz), 6.23(t, 2H, J = 2.30 Hz) , 6.33-6.37(ddd, 2H, J = 7.83, 2.43 0.82 Hz), 6.61(t, 2H, J = 2.43 Hz), 6.67(t, 1H, J = 2.43 Hz), 6.71-6.80(m, 6H), 6.99(t, 2H, J = 7.83 Hz), 7.35(t, 2H, J = 7.83 Hz), 7.38(t, 1H, J = 7.83 Hz) FD-mass 476(M+)
1,3-bis(3-(3-(3-aminophenoxy)phenoxy)phenoxy)benzene: ¹H-NMR (CD3SOCD3) δ: 5.21 (s, 4H), 6.11-6.12(ddd, 2H, J = 7.83, 2.16, 0.81 Hz), 6.21(t, 8H, J = 2.16 Hz), 6.31-6.36(ddd, 2H, J = 7.83, 2.16 0.81 Hz), 6. 67-6. 82 (m, 13H), 6.98(t, 8H, J = 8.10 Hz), 7.31-7.42(m, 5H) FD-mass 660(M+)
1,3-bis(3-(3-maleimidophenoxy)phenoxy)benzene: ¹H-NMR (CDCl3) δ: 6.72(t, 3H, J = 2.30 Hz), 6.79-6.83(dd, 6H, J=7.83, 2.43 Hz), 7.05-7.08(m, 5H), 7.12-7.16(m, 5H), 7.34-7.51(m, 5H) FD-mass 636(M+)

### EXAMPLE 5

A container equipped with a stirrer and a nitrogen-introducing pipe was charged with 855 g of N, N-dimethylacetamide as a solvent, to which was then added 69.16 g of 1, 3-bis (3-aminophenoxy)benzene. The mixture was stirred at ambient temperature until it was dissolved. Thereafter, 75.84 g of 3,3',4,4'-benzophenonetetracarboxylic dianhydride was added to the solution and the obtained mixture was stirred at 60°C to obtain a polyamic acid solution, in which the content of polyamic acid was 15% by weight. 48.3 g of 1, 3-bis (3-maleimidophenoxy)benzene was added to a part (500 g) of the obtained varnish and the mixture was stirred at ambient temperature for 2 hours.

Using a commercially available polyimide resin film (product name: Kapton (trademark) 150EN, manufactured by Toray Du Pont Co., Ltd.), a part of the bismaleimide compound-containing polyamic acid solution obtained in the above method was coated on the film using a roll coater such that the thickness after drying was 2 µm and dried at 115°C for 2 minutes, at 150°C for 2 minutes, at 180°C for 2 minutes, at 240°C for 2 minutes and at 265°C for 2 minutes in an air-float system drier to obtain an insulating film having a layer of thermoplastic polyimide resin on one side. Thereafter, a metal foil and the insulating film were laminated on a commercially available electrolytic copper foil (FO-WS, manufactured by Furukawa Circuit Foil Co., Ltd., 9 µm) using a roll laminator at 240°C under a pressure of 1.5 MPa. Then, the resulting product was annealed at 280°C for 4 hours in a nitrogen atmosphere using a batch type autoclave to obtain a polyimide metal laminate. The solder heat-resistant temperature of the obtained polyimide metal laminate was 320°C. Also, in order to confirm whether voids were present on the interface between the copper foil and the polyimide or not, both the section of the interface and a surface of the polyimide from which the copper foil had been removed by means of etching were observed at a magnification of 1,250. No voids were observed.

### EXAMPLES 6 to 13

The same procedures as in Example 5 as to polymerization, formulation, lamination and evaluation were conducted except that the type and amount of the diamine, dianhydride and bismaleimide compound were altered. The types, amounts and results are shown together in Table 2. Voids on the interface between the copper foil and the polyimide were not observed in all the samples.

### EXAMPLE 14

A container equipped with a stirrer and a nitrogen-introducing pipe was charged with N,N-dimethylacetamide as a solvent such that the content of polyamic acid was 15% by weight, to which were then added p-phenylenediamine and 3,4-oxydianiline in ratios of 30 mol% and 70 mol% respectively. The mixture was stirred at ambient temperature until it was dissolved. Thereafter, 3,3',4,4'-benzophenonetetracarboxylic dianhydride was added to the solution in an amount of 0.985 mol when the total mol of the diamine was 1 and the resulting mixture was stirred at 60°C to obtain a polyamic acid solution.
1, 3-bis (3-maleimidophenoxy)benzene was added to the resulting varnish in an amount of 40 wt% to the polyamic acid and the mixture was stirred at ambient temperature for 2 hours.

A part of the obtained polyamic acid solution containing the bismaleimide compound was taken and cast on a glass plate and heated from 50°C to 270°C at a temperature rise rate of 7°C /min to obtain a film having the thickness of 20 µm. The glass transition temperature (Tg) of the obtained polyimide film was 220°C.

Also, using a commercially available polyimide resin film (product name: Kapton (trademark) 150EN, manufactured by Toray Du Pont Co., Ltd.), another part of the obtained bismaleimide compound-containing polyamic acid solution was coated on the film using an applicator such that the thickness after drying was 2 µm and dried at a temperature rise rate of 7°C /min in a temperature range from 50°C to 270°C to obtain an insulating film having a layer of thermoplastic polyimide resin on one side. Thereafter, the insulating film was laminated on a commercially available electrolytic copper foil (FO-WS, manufactured by Furukawa Circuit Foil Co., Ltd., 9 µm) and dried at 130°C for about one hour, followed by pressing at 300°C under a pressure of 2.5 MPa for 4 hours to adhere the copper foil to the insulating film, thereby obtaining a polyimide/metal laminate. No void was observed on the interface between the copper foil and the polyimide. Also, a peeling test was made and as a result, the peel strength was 0.85 kN/m.

### EXAMPLES 15 and 16

The same procedures as in Example 14 as to polymerization, formulation, lamination and evaluation were conducted except that the type and amount of the diamine, dianhydride and bismaleimide were altered. The results are shown together in Table 3. No void was observed on the interface between the copper foil and the polyimide in all samples.

### COMPARATIVE EXAMPLE 1

The same procedures as in Example 1 as to polymerization, formulation and evaluation were conducted except that the bismaleimide compound was not compounded. The types, the amounts and the results are shown together in Table 1. The peel strength was 0 kN/m, which means the copper foil and the polyimide were not bonded with each other at all.

### COMPARATIVE EXAMPLE 2

A container equipped with a stirrer and a nitrogen-introducing pipe was charged with 855 g of N, N-dimethylacetamide as a solvent, to which was then added 69.16 g of 1, 3-bis (3-aminophenoxy)benzene. The mixture was stirred at ambient temperature until it was dissolved. Thereafter, 75.84 g of 3,3',4,4'-benzophenonetetracarboxylic dianhydride was added to the solution and the resultant mixture was stirred at 60°C to obtain a polyamic acid solution, in which the content of polyamic acid was 15% by weight.

Using a commercially available polyimide resin film (product name: Kapton (trademark) 150EN, manufactured by Toray Du Pont Co., Ltd.), a part of the obtained bismaleimide compound-containing polyamic acid solution was coated on the film using a roll coater such that the thickness after drying was 2 µm, and dried at 115°C for 2 minutes, at 150°C for 2 minutes, at 180°C for 2 minutes, at 240°C for 2 minutes and at 265°C for 2 minutes in an air-float system drier to obtain an insulating film having a layer of thermoplastic polyimide resin on one side. Thereafter, a metal foil and the insulating film were coated on the commercially available electrolytic copper foil that was used in Example 5 using a roll laminator at 240°C under a pressure of 1.5 MPa. Then, the obtained product was annealed at 280°C for 4 hours in a nitrogen atmosphere using a batch type autoclave to obtain a polyimide/metal laminate. The solder heat-resistant temperature of the obtained polyimide metal laminate was 260°C. Also, voids having the sizes of from about several µm to tens of µm were observed on the interface between the copper foil and the polyimide.

### COMPARATIVE EXAMPLES 3 to 5

The same procedures as in Examples 14, 15 and 16 as to polymerization, formulation and evaluation were conducted except that the bismaleimide compound was not compounded. The results are shown together in Table 3. The peel strength was 0 kN/m, which means the copper foil and the polyimide were not bonded with each other at all, and therefore the evaluation of voids could not be made.

**[Table 1]**

| | Diamine compound*1 | dianhydride*2 | Bismaleimide compound*3 | Tg (DSC method) | Peel strength |
|---|---|---|---|---|---|
| Unit | mol | mol | wt% | °C | kN/m |
| Example 1 | APB 0.0410 | BTDA 0.0369 | APB-BMI 40 | 106 | 1.6 |
| Example 2 | APB5 0.0329 | BTDA 0.0312 | APB-BMI 20 | 116 | 2.4 |
| Example 3 | APB5 0.0329 | BTDA 0.0313 | APB-BMI 15 | 125 | 1.6 |
| Example 4 | APB7 0.0200 | BTDA 0.0190 | APB-BMI 10 | 115 | 2.2 |
| Comparative Example 1 | APB 0.0410 | BTDA 0.0369 | - | 195 | 0 |

**[Table 2]**

| | Diamine compound*1 | dianhydride*2 | Bismaleimide compound*3 | Solder heat resistance |
|---|---|---|---|---|
| | mol | mol | wt% | °C |
| Example 5 | APB 0.2366 | BTDA 0.2354 | APB-BMI 25 | 320 |
| Example 6 | APB 0.2366 | BPDA 0.2354 | APB-BMI 20 | 300 |
| Example 7 | DAPB 0.2366 | BTDA 0.2354 | APB-BMI 40 | 350 |
| Example 8 | m-BP 0.2366 | PMDA 0.2354 | APB-BMI 40 | 350 |
| Example 9 | APB5 0.2366 | BTDA 0.2354 | APB-BMI 20 | 320 |
| Example 10 | ODA 0.2366 | BTDA 0.2354 | APB-BMI 40 | 360 |
| Example 11 | APB 0.2366 | BTDA 0.2354 | BMI-MP 25 | 350 |
| Example 12 | APB 0.2366 | BTDA 0.2354 | BMI-S 25 | 350 |
| Example 13 | DABP 0.2366 | ODPA 0.2354 | BMI-S 10 | 320 |
| Comparative Example 2 | APB 0.2366 | BTDA 0.2354 | - | 260 |

**[Table 3]**

| | Diamine compound*1 | dianhydride*2 | Bismaleimide compound*3 | Tg (solid visco-el astic method) | Peel strength |
|---|---|---|---|---|---|
| | mol | mol | wt% | °C | kN/m |
| Example 14 | 3,4'-ODA (70 mol%) 0.0150 PPD (30mol%) 0.0064 | BTDA 0.0211 | APB-BMI 40 | 220 | 0.85 |
| Comparative Example 3 | 3,4'-ODA (70 mol%) 0.0150 PPD (30mol%) 0.0064 | BTDA 0.0211 | - | 290 | 0 |
| Example 15 | ODA (70 mol%) 0.0150 m-BP (30mol%) 0.0064 | PMDA 0.0211 | APB-BMI 40 | 260 | 0.7 |
| Comparative Example 4 | ODA (70 mol%) 0.0150 m-BP (30mol%) 0.0064 | PMDA 0.0211 | - | 340 | 0 |
| Example 16 | ODA (70 mol%) 0.0150 PPD (30mol%) 0.0064 | PMDA (50 mol%) 0.0105 BPDA (50mol%) 0.0105 | APB-BMI 40 | 242 | 0.6 |
| Comparative Example 5 | ODA (70 mol%) 0.0150 PPD (30mol%) 0.0064 | PMDA (50 mol%) 0.0105 BPDA (50mol%) 0.0105 | - | 320 | 0 |

| | | | | | |
|---|---|---|---|---|---|
| Note*1) APB: 1,3-bis(3-aminophenoxy)benzene APB5: 1,3-bis(3-(3-aminophenoxy)phenoxy)benzene APB7: 1,3-bis(3-(3-(3-aminophenoxy)phenoxy)phenoxy)benzene DABP: 3,3'-diaminobenzophenone m-BP: 4,4'-(3-aminophenoxy)biphenyl ODA: 4,4'-oxydianiline(4,4'-diaminodiphenyl ether) 3,4'-ODA: 3,4'-oxydianiline(3,4'-diaminodiphenyl ether) PPD: p-phenylenediamine | | | | | |
| *2) BTDA: 3,3',4,4'-benzophenonetetracarboxylic dianhydride BPDA: 3,3',4,4'-biphenyltetracarboxylic dianhydride ODPA: 3,3',4,4'-diphenyl ether tetracarboxylic dianhydride PMDA: Pyromellitic anhydride | | | | | |
| *3) APB-BMI: 1,3-bis(3-maleimidephenoxy)benzene APB5-BMI: 1,3-bis(3-(3-maleimidephenoxy)phenoxy)benzene BMI-MP: N,N'-m-phenylenebismaleimide BMI-S: Bis(4-maleimidephenyl)methane | | | | | |

The resin composition of the present invention is superior in low-temperature adhesiveness due to the effect of decreasing Tg and may be preferably used, for example, as heat-resistant adhesives for use in the field of electronics.

Also, according to the present invention, no void remains on the interface between a metal and polyimide and a laminate having high adhesive strength is obtained without applying a high processing temperature. Also, a polyimide metal laminate, which hardly generate swelling even in a step of packaging LSI chips and parts or in their repairing step and is superior in solder heat resistance in spite of the severe working temperature conditions in these steps, can be provided.

## Claims

1. A metal laminate comprising:
a layer of a resin composition obtainable by compounding a bismaleimide compound represented by the following formula (1) in a polyamic acid and/or a polyimide : 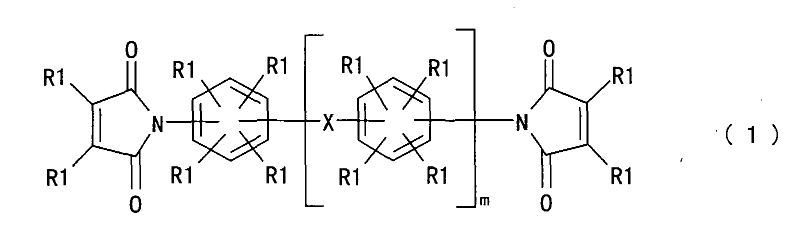 wherein m denotes an integer of 0 or more, each X independently represents O, SO₂, S, CO, CH₂, C(CH₃)₂, C(CF₃)₂ or a direct bond and each R1 independently represents a hydrogen atom, a halogen atom or a hydrocarbon group and is independent of any other as to the substitution position on the benzene ring; and
a metal foil layer,
wherein the layer of the resin composition is formed on at least one surface of the metal foil layer.

2. The metal laminate according to Claim 1, wherein the metal laminate has a structure in which the layer of the resin composition is formed on one surface or both surfaces of one or more polyimide film(s) and the metal foil layer is formed on one surface or both surfaces of the layer of the resin composition.

3. The metal laminate according to Claim 1, wherein the polyamic acid and/or the polyimide have repeat structural units represented by the following formula (2) and/or formula (3) respectively: 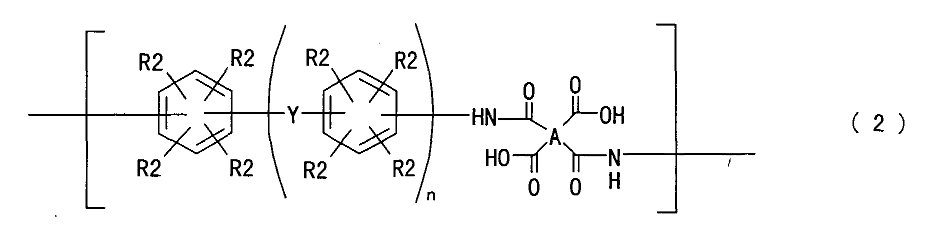 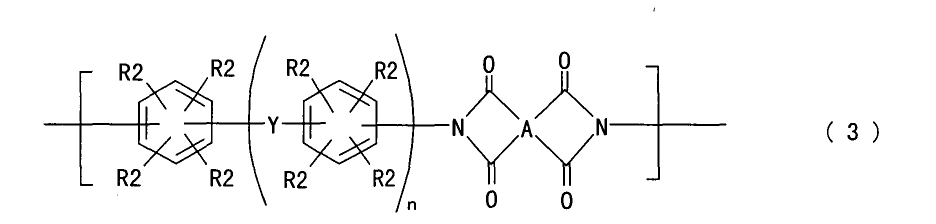 wherein n denotes an integer of 0 or more, each Y independently represents O, SO₂, S, CO, CH₂, C(CH₃)₂, C(CF₃)₂ or a direct bond, A represents a tetravalent organic group and each R2 independently represents a hydrogen atom, a halogen atom or a hydrocarbon group and is independent of any other R2 as to the substitution position on the benzene ring.

4. The metal laminate according to Claim 3, wherein the tetravalent organic group represented by A is selected from the organic groups represented by the following formulae shown in (4) : 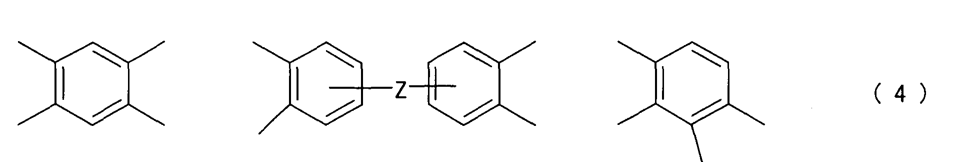 wherein Z represents O, SO₂, S, CO, CH₂, C(CH₃)₂, C(CF₃)₂ or a direct bond.

5. A resin composition for polyimide/metal laminate obtainable by compounding a bismaleimide compound represented by the following formula (1) in a polyamic acid and/or a polyimide: 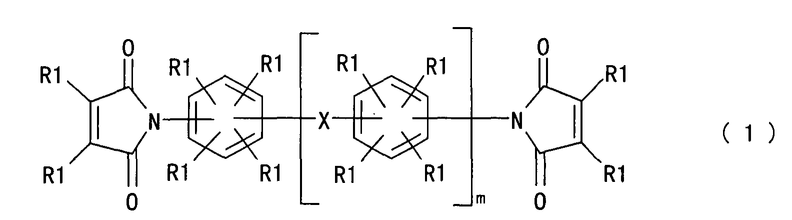 wherein m denotes an integer of 0 or more, each X independently represents O, SO₂, S, CO, CH₂, C(CH₃)₂, C(CF₃)₂ or a direct bond and each R1 independently represents a hydrogen atom, a halogen atom or a hydrocarbon group and is independent of any other R1 as to the substitution position on a benzene ring.

6. A resin composition for polyimide/metal laminate comprising:
a bismaleimide compound represented by the following formula (1): 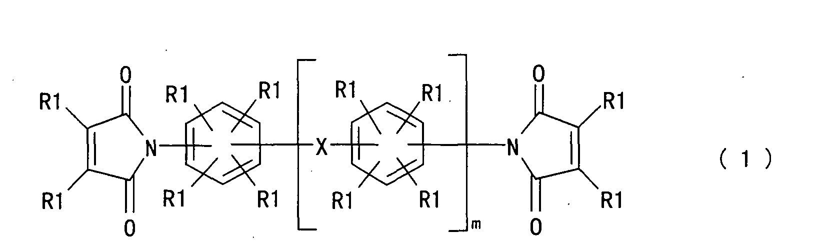 wherein m denotes an integer of 0 or more, each X independently represents O, SO₂, S, CO, CH₂, C(CH₃)₂, C(CF₃)₂ or a direct bond and each R1 independently represents a hydrogen atom, a halogen atom or a hydrocarbon group and is independent of any other R1 as to the substitution position on a benzene ring; and
a polyamic acid and/or a polyimide.
